Europäisches Patentamt

European Patent Office

Office européen des brevets

(11) Publication number: **0 028 096**
A1

# EUROPEAN PATENT APPLICATION

(21) Application number: 80303631.8

(22) Date of filing: 15.10.80

(51) Int. Cl.³: **B 23 C 1/16,** H 05 K 3/00, B 23 Q 11/02

(30) Priority: 15.10.79 GB 7935749

(43) Date of publication of application: 06.05.81 Bulletin 81/18

(84) Designated Contracting States: **AT CH DE FR GB IT LI SE**

(71) Applicant: **EXCELLON INTERNATIONAL INCORPORATED, 23915 Garnier Street, Torrance California 90509 (US)**

(72) Inventor: **Beetlestone, Frederick Rogers Minton, 34 Glebelands, Pulborough West Sussex (GB)**
Inventor: **Hull, Patrick Thomas Michael, 2 Fontwell Close, Rustington West Sussex (GB)**

(74) Representative: **Booth, Philip Charles et al, LLOYD WISE, TREGEAR & CO. Norman House 105-109 Strand, London, WC2R OAE (GB)**

(54) **Routing machine.**

(57) A routing machine having an A-frame (6) with a spindle (8) rotatably mounted at the apex (7) thereof to support a collet (24) for attaching a router bit (25), the divergent legs (5) of the A-frame (6) being rotatably supported on a shaft (3) secured to a base (1) having a plane surface (14) defining a work top. The axis (19) of the shaft (3) is located at a height above the work top substantially equal to half the height of the work (20) to be routed and the ratio of the distance (6) between the spindle (8) and the mid point of the shaft (3) between the divergent legs (5) and the distance (D) between that mid point and each leg (5) is not greater than about 5:1.

;1;

TITLE:  ROUTING MACHINE

This invention relates to a routing machine which whilst being particularly adapted for the plunge-routing of printed circuit boards is not limited thereto in its application.

It is common practice when producing identically shaped cut-outs in a number of workpieces to use a template so that each workpiece is routed out in an identical manner.  Each workpiece may in turn be pinned to the template, or where each workpiece is thin or the router provides a sufficient depth of cut, a plurality of workpieces may be pinned to the template which is manoeuvred against a guide pin so that the router bit cuts out an aperture identical in shape to that in the template.  To maintain accuracy in the position and dimensions of the cut-outs in each of a number of workpieces it is essential that the position of the router bit relative to the guide pin is accurately maintained. This is often achieved in plunge routers by mounting the spindle to which the router bit is secured by means of a collet or chuck in a vertical slideway, the router bit being plunged into one or a stack of workpieces by lowering the spindle down the sideway.  However routing printed circuit boards made of glass reinforced plastics material produces highly abrasive dust which rapidly wears away the surfaces of the slideway and spindle, resulting in a loss in positional accuracy of the router bit.  One way to overcome this problem is to remove the mechanism for lowering the router bit spindle into a workpiece from the site of the routing operation.  This can be achieved by rotatably mounting the spindle in an overhanging arm pivoted to a base on which  the workpiece is placed.  The length of the overhang must be sufficient to avoid abrasive dust from the routing operation affecting the pivot bearings but the longer the overhang the smaller are the tolerances that can be permitted in the pivot bearings. Where a sideways movement of less than 0.01 mm is to be achieved at the spindle, a long overhang becomes impractical. However a long overhang is desirable to reduce the curvature of cut as the router bit plunges into the workpiece on pivoting the arm down towards the base.

A satisfactory compromise in the conflict between the requirement of a long overhang and the difficulty in producing pivot bearings having extremely low tolerances at an economic price is achieved by the invention disclosed herein by using a substantial casting in the form of an A-frame for the arm carrying the router bit spindle and using a novel form of bearing for pivotally mounting the arm on a shaft.

Furthermore a novel form of dust extraction device can be mounted about the router bit to prevent dust and swarf from entering the pivot and spindle bearings without obscuring a view of the workpiece as it is manoeuvred beneath the router bit.

It is an object therefore of this invention to provide an improved routing machine in which the working parts are protected against wear by dust and swarf produced by routing.

It is a further object of this invention to provide a plunge-type routing machine which will accurately rout a plurality of printed circuit boards made of glass reinforced plastics material without loss of accuracy.

In accordance with this invention therefore we provide a routing machine comprising, a base having a plane surface, a rigid frame which in cross-section is A-shaped having divergent legs, a spindle rotatably mounted near the apex of the A-frame, means for retaining a router bit on said spindle, and means pivoting the divergent legs of said A-frame to said base to enable the router bit to be plunged into a workpiece supported on said plane surface along an arcuate path; the axis of said pivoting means being at a height above said plane surface substantially equal to the mid-height of said workpiece placed on said plane surface, and the ratio of the distance between the axis of the spindle and the mid point between the divergent legs at which said A-frame is pivoted and the distance between said mid point and said pivoting means being no greater than five to one.

A preferred embodiment of the invention to be described in detail hereinafter comprises a bench-standing single-spindle pin-routing machine with a specially developed A-frame and molecular tolerance pivot for alignment rigidity. High stability, low stress castings form an articulated arm and base frame. A granite work table and a high mass construction of the arm and base on which the work table is supported form a low vibration, low noise pad and overarm. A one and one-half horsepower brushless motor is provided to drive a low mass reinforced polymer belt trained about a precision nine bearing spindle having a self-extracting collet. The spindle is rigidly mounted near the end of the apex of the A-frame. Vernier lateral adjustment of the A-frame is provided to provide alignment of the router bit with a guide pin set in the granite work table. A dust-extraction device in the form of an air curtain and forced vortex extraction cup is mounted at the lower end of the spindle and about the router bit held in the collet.

In order that the invention may be fully understood a preferred embodiment thereof will now be described with reference to the accompanying drawings in which:-

Figure 1 is a side view of a routing machine in accordance with this invention;

Figure 2 is a rear view of the machine shown in Figure 1;

Figure 3 is a plan view of the machine shown in Figure 1;

Figure 4 is an isometric view of a dust-extraction device of the machine shown in Figure 1, and

Figure 5 is an underside view of the device shown in Figure 4.

Referring now to the drawings, the routing machine comprises a base casting 1 having an upstanding rear portion 2 carrying a 30 mm diameter hardened and ground steel shaft 3 about which is pivoted the ends 4 of divergent legs 5 of a substantial cast A-frame 6 having rotatably mounted near the apex 7 thereof a nine bearing spindle 8 driven by a low mass reinforced polymer belt 9 coupled in a pulley 10 to a brushless 1½ h.p. a.c. motor 11 hinged to one leg 5 of the A-frame 6.

Lugs 12 extending from the base 1 are secured to the forward part of a granite work table 13 having a plane lapped surface 14, the rear part of the table 13 being slideably supported on lugs 15 to allow for expansion of the base 1. Clamps 16 clamp the shaft 3 down onto the upper surface 17 of the upstanding rear portion 2 by means of bolts 18 so that the axis 19 of the shaft 3 is at a height substantially equal to the mid-height of work 20 placed on the table 13.

Bearings 21 in apertures 22 at the rear end of the cast A-frame 6 encircle the shaft 3 and provide molecular tolerance bearings for pivoting the A-frame about the axis 19. The bearings 21 are formed by first jigging the shaft 3 coated with a release agent in position in apertures 22 and then injecting an epoxy resin compound which cures with minimum shrinkage. The resultant clearance in the bearings so formed is equal to the shrinkage plus the thickness of the release agent on the shaft.

A removable guide pin 23 is provided in the table 13 beneath the spindle 8 which has a collet 24 to securely hold a router bit 25. Adjusting means 26 at the rearward end of one leg 5 of the A-frame 6 provides for sideways positioning of the A-frame 6 on the shaft 3 to align or offset the bit 25 from the guide pin 23. Adjusting means 26 comprise a calibrated knurled adjusting wheel 27 rotatable within a cylindrical cup-shaped housing 28 secured to the face of the leg 5. A threaded shaft 29 extends from one side of the wheel 27 into the leg 5 and a member 30 extending from the opposite side has pivoted thereto a lever 31 whose distal end is pivoted to a block 32 secured to the leg 5 about the shaft 3. A nose portion 33 of the lever 31 engages a domed end 34 of a flanged bushing 35 slideably mounted in a bore 36 at one end 37 of a recess 38 centrally located in the block 32. The bushing 35 encircles a pin 39 mounted centrally in the shaft 3 and a helical spring 40 is located between the flanged portion of the bushing and the end 37 of recess 38.

Thus rotation of the wheel 27 in a direction to move it away from the leg 5 results in the nose portion 33 of lever 31 pushing against bushing 35 which, bearing against shaft 3 causes the pivot point of lever 31 to draw the block 32 and thereby the A-frame along the shaft 3 to the right as viewed in Figure 2. This causes compression of the spring 40 so that on rotation of the wheel 27 in the opposite direction, the spring 40 urges the block 32 back along the shaft 3.

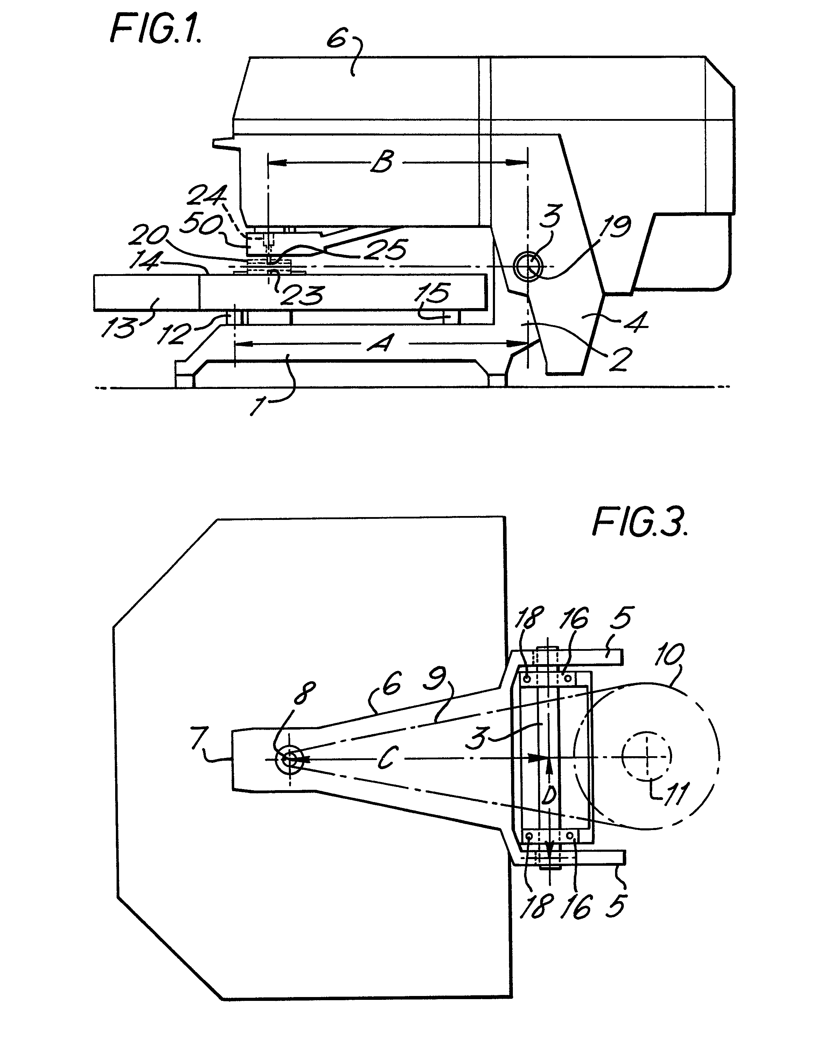

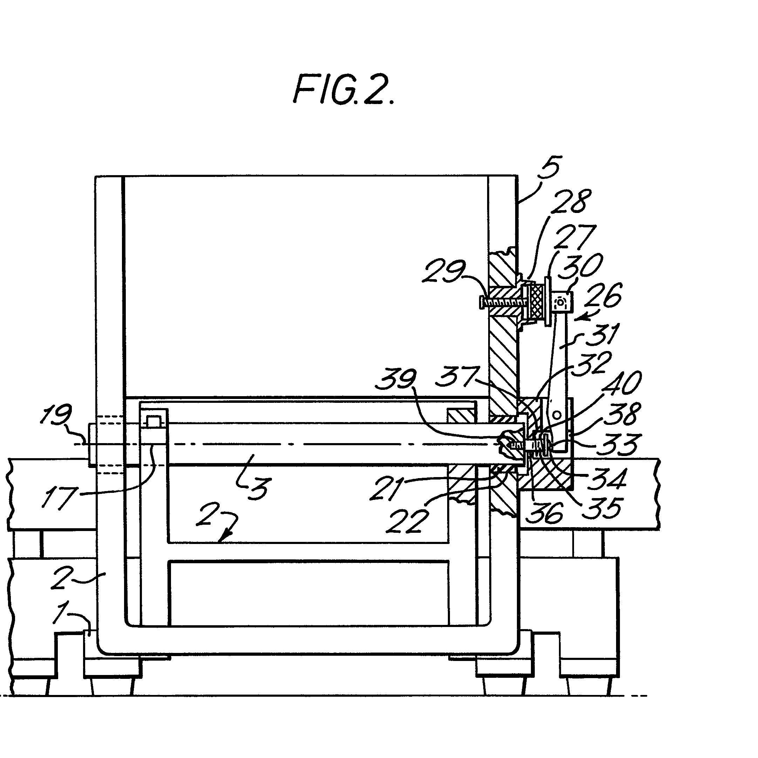

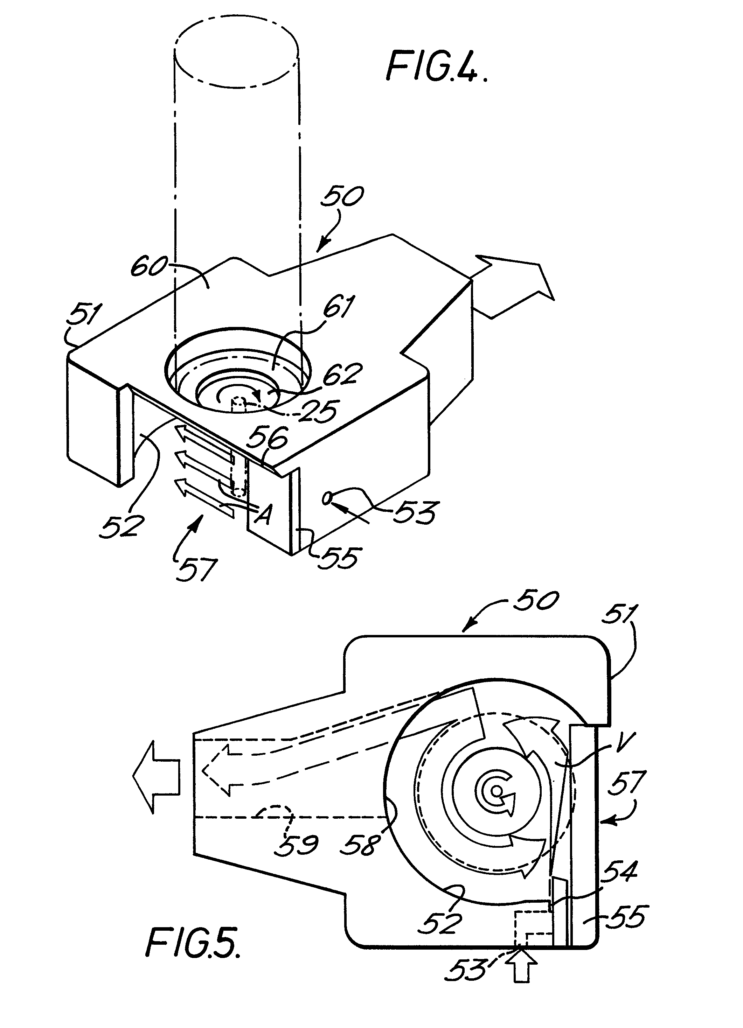

As viewed in Figure 1, the distance B between the axis of the spindle 8 and the axis 19 of the shaft 3 is not much less than the distance A between axis 19 and the lugs 12 to eliminate, as far as possible, differential expansion between the A-frame and base castings. Furthermore, the distance C between the axis of spindle 8 and the mid-point of the shaft 3, as shown in Figure 3 is about 15 inches in this embodiment and the distance D between the mid-point of the shaft 3 and the mid-plane of a bearing 21 is about 6 inches giving a ratio of 2.5:1. Assuming 0.005mm play in each bearing 21, pressure on one side of the A-frame at the location of the spindle 8 will cause each end of the shaft 3 to move 0.0025mm in opposite directions from a rest position allowing the spindle 8 to move 0.0063 mm.

Ratios greater than about 2.5:1 require a greater divergence of the legs of the A-frame and a smaller tolerance in the bearings if sideways movement of the spindle is to be kept to a minimum. Increasing the aforementioned ratio means, in practice, increasing the size and hence the bulk and weight of the A-frame and we have found that a ratio of about 5:1 is the maximum that can be tolerated for a machine that provides accuracy in routing with the minimum size and bulk and the lowest cost.

This provides a high order of accuracy in maintaining the spindle 8 and thus the router bit, in a predetermined position relative to the guide pin 23 whether or not the router bit is aligned with the pin 23 or is offset therefrom by the adjusting means 26.

In operation a stack of printed circuit boards pinned to a template is placed on the table 13 with the pin 23 engaging a surface of one of the cut-outs in the template to be repeated in the workpieces. The A-frame is then pivoted down plunging the router bit into the stack which is then manoeuvred around the contours of the cut-out in the template to complete the routing operation for that particular cut-out. The height of the stack may be of the order of 0.25 inches which, for an A-frame dimension C of 15 inches gives a ratio of 1:60. Thus the difference in dimensions between the cut-outs of the top and bottom workpieces and the central one will be in the order of 16,000:1 due to the arcuate nature of the plunge routing operation and the fact that the axis 19 is at the mid-height of the stack of workpieces above the surface 14 of the table 13.

As shown in Figure 1, 4 and 5, a dust extractor device 50 is provided secured to the underside of the A-frame 6 about the router bit held in a collet secured

0028096

;8;

to the spindle 8. The device 50 comprises a housing 51 having a part-cylindrical recess 52 into which is fed compressed air from a source (not shown) via an inlet 53 and a slit 54 formed by a plate 55 secured to one side 56 of the mouth 57 of housing 51, the plate 55 having a relieved portion to provide the narrow slit 54 which forms a curtain of air A across the mouth 57. The air curtain impinges on the opposite arcuate side of the recess 52 to form a vortex V lowering the pressure at the entrance 58 of a rear passageway 59 which may, if desired, be coupled to a vacuum source. The rotational direction of the vortex is the same as that of the router bit which thereby helps in creating the vortex.

On the top face 60 of the housing 51 is a cylindrical recess 61 which opens out at 62 into the recess 52 so that a vortex created in the recess 52 produces a negative pressure area in recess 61 causing an airflow into recess 52 past the end of the spindle 8 thus keeping it free of swarf and dust.

The air curtain across the mouth 57 of the housing 51 enables the operator to view the routing operation with reasonable safety and prevents much of the dust and swarf being thrown out towards the operator. It is not essential to provide either a source of compressed air or a vacuum source as a vortex will be created on rotation of the router bit setting up an air curtain across the mouth of the housing and ejecting swarf and dust out of the housing via the passageway 59.

It will be appreciated from the above description of a preferred embodiment of the invention that a versatile, rigid, highly accurate routing machine is provided which contributes to operator safety, is easy to use and whose pivot and spindle bearings are protected from the abrasive action of dust produced when routing.

;10;

CLAIMS:

1. A routing machine comprising, a base having a plane surface, a rigid frame which in cross-section is A-shaped having divergent legs, a spindle rotatably mounted near the apex of the A-frame, means for retaining a router bit on said spindle, and means pivoting the divergent legs of said A-frame to said base to enable the router bit to be plunged into a workpiece supported on said plane surface along an arcuate path; the axis of said pivoting means being at a height above said plane surface substantially equal to the mid-height of said workpiece placed on said plane surface, and the ratio of the distance between the axis of the spindle and the mid-point between the divergent legs at which said A-frame is pivoted and the distance between said mid point and said pivoting means being no greater than five to one.

2. A routing machine according to Claim 1 wherein said pivoting means includes a shaft, means supporting said shaft on said base, and a bearing located in each said divergent leg and encircling said shaft; said machine further including means to adjust the position of said divergent legs axially along said shaft.

3. A routing machine according to Claim 2 wherein said adjusting means includes a wheel rotatably mounted on one divergent leg of said A-frame and means coupling said wheel to one end of said shaft so that on rotation of said wheel the A-frame is drawn axially along said shaft.

4. A routing machine according to Claim 3 wherein said wheel includes a member about which said wheel rotates and said coupling means comprises a block fixed to said one divergent leg of said A-frame about said one end of said shaft, a sprung loaded pin mounted in said block coaxial with said shaft, a lever pivoted to said block and having a nose portion bearing against said pin with the opposite end of said lever pivoted to said member; said machine further including a threaded mount for said wheel so that as the wheel is rotated it moves away from said one divergent leg together with said member to pivot said lever to push said pin against said shaft and move said A-frame therealong.

5. A routing machine according to any one of Claims 1 to 4 wherein said base comprises a base plate, a work table having said plane surface and means supporting said table over said base plate to allow for differential expansion therebetween.

6. A routing machine according to Claim 5 wherein said supporting means includes lugs fixing that part of said table beneath said spindle to said base plate, and fixed to said base plate adjacent said pivoting means, further lugs to allow said table to slide thereover.

7. A routing machine according to Claim 1 wherein said base includes an upstanding rear portion and said pivoting means includes a shaft and bearings located in said divergent legs and encircling said shaft, said machine further including means to clamp said shaft on said upstanding rear portion.

8. A routing machine according to Claim 1 wherein said pivoting means includes a shaft and bearings located in said divergent legs and encircling said shaft, said bearings being formed of epoxy resin cured after injection between said shaft and said legs.

9. A routing machine according to any one of Claims 1 to 8 including a dust extractor detachably secured to the apex of said A-frame about said means for retaining a router bit on said spindle, said dust extractor comprising a block defining a recess concentric with said spindle and having a mouth through which an operator can see said retaining means, means for producing an air curtain across said mouth and a vortex in said recess, and means for withdrawing from said recess dust and swarf produced by a routing operation of said machine.

LLOYD WISE, TREGEAR & CO.
NORMAN HOUSE 105-109 STRAND
LONDON, WC2R 0AE

0028096

FIG.1.

FIG.3.

FIG.2.

FIG.4.

50
60
51
61
62
25
56
52
57
A
53
55

50
51
V
57
54
55
52
58
59
53

FIG.5.

## DOCUMENTS CONSIDERED TO·BE RELEVANT

| Category | Citation of document with indication, where appropriate, of relevant passages | Relevant to claim |
|---|---|---|
| | FR - A - 747 233 (S.A. DES USINES CHAUS-SON) <br> * claim 1 * <br> -- | 1,5,7 |
| | US - A - 3 837 383 (K. KO) <br> * claim 1; column 2, lines 5 to 45; column 3, lines 30 to 37 * <br> -- | 9 |
| | US - A - 3 880 047 (P.A. DOSIER) <br> * claim 1 * <br> -- | 9 |
| | US - A - 2 177 347 (H.A. SEDELMEYER et al.) <br> * page 2, left column, lines 43 to 51 * <br> -- | 9 |
| A | US - A - 2 507 982 (T.P. KRAUSE) <br> -- | |
| A | US - A - 1 753 206 (J.E. JOHNSON) <br> -- | |
| A | Patents Abstracts of Japan, Vol. 2, No. 18, 7 February 1978 <br> page 7147M77 <br> & JP - A - 52 133195 <br> ---- | |

**CLASSIFICATION OF THE APPLICATION (Int. Cl.³)**

B 23 C   1/16
H 05 K   3/00
B 23 Q  11/02

**TECHNICAL FIELDS SEARCHED (Int. Cl.³)**

B 23 C   1/16
B 23 Q  11/00
B 23 Q  35/10
B 28 D   5/02
B 44 B   1/02
B 44 B   3/00
H 05 K   3/00

**CATEGORY OF CITED DOCUMENTS**

X: particularly relevant
A: technological background
O: non-written disclosure  .
P: intermediate document
T: theory or principle underlying the invention
E: conflicting application
D: document cited in the application
L: citation for other reasons

&: member of the same patent family, corresponding document

| | | | |
|---|---|---|---|
| X | The present search report has been drawn up for all claims | | |

| Place of search | Date of completion of the search | Examiner |
|---|---|---|
| Berlin | 27-01-1981 | MARTIN |

EPO Form 1503.1  06.78